# EUROPÄISCHE PATENTSCHRIFT

(11) **EP 1 335 787 B1**
(45) Veröffentlichungstag und Bekanntmachung des Hinweises auf die Patenterteilung: **09.03.2005**
(21) Anmeldenummer: 01992604.7
(22) Anmeldetag: 02.10.2001
(51) Int. Cl.: B01D 46/42, H05K 7/20, F04D 25/12, F24F 13/28

(54) **VORRICHTUNG ZUM FILTERN VON LUFT**
DEVICE FOR FILTERING AIR
DISPOSITIF DE FILTRAGE D'AIR

(30) Priorität: 31.10.2000 DE 20018582 U
(43) Veröffentlichungstag der Anmeldung: 20.08.2003
(73) Patentinhaber: Pfannenberg GmbH, 21035 Hamburg (DE)
(72) Erfinder: PFANNENBERG, Andreas, 21035 Hamburg (DE)
(74) Vertreter: Richter, Werdermann, Gerbaulet & Hofmann
(86) Internationale Anmeldenummer: PCT/EP2001/011387
(87) Internationale Veröffentlichungsnummer: WO 2002/036241

(56) Entgegenhaltungen:
- EP-A- 0 575 038
- DE-A- 19 700 065
- DE-U- 20 002 124
- US-A- 5 236 480

## Beschreibung

### Anwendungsgebiet

Die Erfindung betrifft einen Luftfiltereinsatz für Filterlüfter gemäß dem Oberbegriff des Anspruches 1 und einen Filterlüfter gemäß dem Oberbegriff des Anspruches 2.

### Stand der Technik

Um die im Innenraum von z. B. elektronische Steuereinrichtungen und Schaltungen enthaltenden Schaltschränken entstehende Wärme abzuführen ist es bekannt, über ein Gebläse dem Schaltinnenraum kalte Frischluft zuzuführen. Das Gebläse ist dann in einer in der Schrankwand ausgebildeten Ausnehmung mittels einer Schraub- oder anderweitige Verbindung gehalten, während für den Luftaustritt an anderer Stelle der Schrankwand Luftaustrittsschlitze oder Luftaustrittsfilter vorgesehen sind.

Herkömmliche Filterlüfter sind dabei mit einer quaderförmigen, massiven Filtermatte versehen, welche in einem entsprechenden Aufnahmevolumen gelagert ist. Durch eine derartige Filtermatte ergeben sich Druckverluste, so dass die Radial- oder Axiallüfter entsprechend stärker ausgelegt sein müssen, um diese Druckverluste aufzufangen.

Durch die US-A-5 236 480 ist ein Luftfilter mit einer in eine Faltenstruktur gelegten Filtermatte bekannt. Dieser Luftfilter, besteht aus einem ersten Bogen aus Filtermaterial, das in eine Zickzack-Form gefaltet ist, wobei auf einer oder beiden Seiten des Filters ein im wesentlichen flacher zweiter Bogen feinmaschigen, luftdurchlässigen Materials sich über die Spitzen der Zickzack-Faltung erstreckt. Der zweite Bogen weist Randbereiche auf, die gegen die Seitenkanten des ersten Bogens aufgefaltet sind, um die Montage der Filtereinheit in einem Rahmen zu erleichtern. Die Faltenstruktur wird bei diesem Luftfilter dadurch erreicht, dass ein Bogen aus Filtermaterial gefaltet und vorgeformt wird, in dem der Bogen parallelen Linien entlang zusammengedrückt wird, die quer zu einer Längsrichtung des Bogens verlaufen. Im Anschluss daran wird Klebstoff auf die Oberund Unterseite des Filterbogens aufgetragen, wobei der Klebstoff nicht in einer durchgehenden Linie aufgetragen wird, sondern in kurzen unterbrochenen Linien. Der Klebstoffauftrag erfolgt dabei derart, dass beim Falten des Filterbogens in einem späteren Herstellungsschritt in eine Zickzackoder Fächerform eine gleichförmige keilartige Erscheinung erhalten wird, bestehend aus offenen Teilen und Spitzenteilen. Als Ergebnis umfasst jede Seite des Filters voneinander beabstandete Kanäle, wobei jeder Kanal von zwei gegenüberliegenden Flächen gebildet wird. Jeder Kanal weist ein breites Ende auf, das vom offenen Teil gebildet wird, und ein enges Ende, das von einem Spitzenteil gebildet wird. Eine Innenkante des Spitzenteils liegt dem offenen Teil gegenüber. Jeder offene Teil ist zwischen den Außenkanten zweier Spitzenteile angeordnet. Jeder Kanal hat einen sich in der Richtung vom breiten Ende zum engen Ende verjüngenden Querschnitt. Diese keilartige Erscheinung wird dadurch erreicht, dass zwei gegenüberliegenden Klebstofftropfen oder Klebstofflinien erlaubt wird, am offenen Teil des Kanals miteinander in Berührung zu kommen, während in der Nähe des engen Endes des Kanals ein Klebstofftropfen nur auf der einen der beiden gegenüberliegenden Flächen des Kanals aufgetragen wird. Als Ergebnis wird erreicht, dass der Kanal am offenen Teil breiter ist, als am engen Ende. Der Klebstoff wird in der gleichen Weise auf der anderen Seite des Filtermaterials aufgetragen. Hiernach wird bei diesem Luftfilter die Faltung der Filtermatte mit einer Hilfsmaßnahme erreicht, nämlich insofern, als die Faltung vermittels eines Klebstoffauftrages geschaffen und aufrechterhalten wird.

Die EP-A-0 575 038 beschreibt einen Abgasfilter mit einer Honigwabenstruktur für Verbrennungsmotoren, umfassend eine Keramikfaser und ein anorganisches Bindemittel, wobei die Keramikfaser hauptsächlich aus Al₂O₃ und SiO₂ besteht, wobei das anorganische Bindemittel Al₂O₃ und SiO₂ enthält, um die genannte Keramikfaser zu binden, und das anorganische Bindemittel nur eine Glasphase aufweist oder eine gemischte Phase aus einer Glasphase und einer Kristallphase, die im Temperaturbereich von 20 bis 1200° C dieselbe Kristallstruktur behält, wodurch im anorganischen Bindemittel jegliches Kristall, wie etwa Quarz, ausgeschlossen wird, das außergewöhnlich starke Ausdehnung durch Kristallphasenübergänge bewirkt, und das Auftreten von Sprüngen verhütet wird.

Aus der DE-U-200 02 124 ist eine Luftdurchtrittseinrichtung für den Einbau in eine Durchbrechung in einer Wand eines Gehäuses eines Schaltschrankes bekannt, wobei die Luftdurchtrittseinrichtung ein Grundgehäuse, ein in bzw. an dem Grundgehäuse klemmend gehaltenes Abdeckgehäuse und eine in dem Abdeckgehäuse gehaltene Filtermatte umfasst, wobei das Grundgehäuse wenigstens ein Federelement zum Eingriff in die Durchbrechung der Wand des Gehäuses aufweist.

Die Ausgestaltung dieser Luftdurchtrittseinrichtung besteht in einer speziellen Ausgestaltung einer Schnellbefestigung der Einrichtung in einer Luftdurchtrittsöffnung an einer Montagewand, und einer Einrichtung zum Ableiten von anfallendem Kondenswasser und ist derart, dass wenigstens ein Federelement nur an der oberen Seite des Grundgehäuses und an der gegenüberliegenden unteren Seite des Grundgehäuses wenigstens ein Klemmkeil derart angeordnet und ausgebildet sind, dass der bzw. die Klemmkeile und das bzw. die Federelemente zusammenwirkend mit einem umlaufenden Rand der Durchbrechung der Wand des Gehäuses die Luftdurchtrittseinrichtung an der Wand haltern; wobei an dem Grundgehäuse gehäuseseitig eine umlaufende Nut zur Aufnahme einer Dichtung gehäuseseitig eine umlaufende Nut zur Aufnahme einer Dichtung derart vorgesehen ist, so dass bei in der Durchbrechung angeordnetem Grundgehäuse die Dichtung zwischen der Wand des Gehäuses und dem Grundgehäuse unter einem vorbestimmten Anpressdruck gehalten ist und wobei an einer in Einbaulage der Luftdruchtrittseinrichtung in Schwerkraftrichtung unten liegenden Seite des Grundgehäuses eine Wanne zur Aufnahme von Kondenswasser ausgebildet ist.

Eine weitere Art einer Schnellbefestigung für einen Filterlüfter für den Einbau in die Wand eines Schaltschrankes ist durch die DE-A-197 00 065 bekannt, wobei der Filterlüfter in einer Durchbrechung in der Montagewand gehalten und befestigt ist. Der Filterlüfter besteht dabei aus einem rahmenförmigen Grundgehäuse mit einem gitterförmigen Boden, einer in das Grundgehäuse eingesetzten Filtermatte, einen auf das Grundgehäuse aufgesetzten und die Filtermatte abdeckenden Designrahmen bzw. Abdeckgehäuse und einem an dem Grundgehäuse befestigten Lüftermotor, wobei das Grundgehäuse an seinem Umfang mit einer schraubenlosen Schnellbefestigungseinrichtung zur Montage des Filterlüfters in der Durchbrechung der Montagewand versehen ist, wobei der Filterlüfter HF-dicht montierbar ist. Der Filterlüfter ist mit einem mit dem Grundgehäuse verbundenen Metalleinsatz versehen, der aus einem Rahmen mit einem gitterförmigen Boden besteht und der mittels Schraub-, Niet- oder Klemmeinrichtungen mit dem Grundgehäuse verbunden ist. Ein derart ausgebildeter Filterlüfter ist HF-dicht in der Durchbrechung der Montagewand gehalten und in dieser mittels der Schnellbefestigung gehalten.

### Aufgabe, Lösung, Vorteil

Vor diesem Hintergrund ist es Aufgabe der vorliegenden Erfindung, eine Vorrichtung zum Filtern von Luft, insbesondere einen Luftfiltereinsatz für Filterlüfter oder Austrittsfilter von Schaltschränken bereitzustellen, bei welcher geringere Druckverluste auftreten, bei der ein höheres Anlagerungsvermögen, ein höherer Abscheidegrad, höhere Standzeit (d. h. längere Betriebszeiten), ein größerer Volumenstrom und geringere Strömungsgeräusche erzielt werden und die einen geringeren Wartungsbedarf als herkömmliche Filtermatten aufweist.

Diese Aufgabe wird durch einen Luftfiltereinsatz mit den Merkmalen des Anspruches 1 sowie einen Filterlüfter mit den Merkmalen des Anspruches 2 gelöst.

Nach Anspruch 1 weist der erfindungsgemäße Luftfiltereinsatz für Filterlüfter von Schaltschränken eine Ausgestaltung auf, nach der die in eine dauerhafte, stabile, plissierte Faltenstruktur gelegte dünne, schichtförmige Filtermatte aus einem Vliesstoff mit einer Oberflächenprofilierung, wie Vertiefungen oder einer Wabenstruktur, versehen ist und eine Faltung mit einem Winkel zwischen zwei benachbarten Faltungsflächen von 15° bis 25°, insbesondere 19°, aufweist und elektrostatisch aufgeladen ist, wobei die Porengröße des Filtermattenmaterials so gewählt ist, dass ein geringer Wasserdurchlass gegeben ist.

Der erfindungsgemäße Filterlüfter für den Einbau in die Wand eines Schaltschrankes, wobei die Montagewand mit einer Durchbrechung versehen ist, in der der Filterlüfter oder Austrittsfilter gehalten und befestigt ist und wobei der Filterlüfter ein Grundgehäuse und einen Deckel enthält, welche zwischen sich ein durch parallele Ebenen begrenztes Volumen zur Aufnahme eines Luftfiltereinsatzes definieren nach Anspruch 2 ist derart ausgebildet, dass der Luftfiltereinsatz eine in eine dauerhafte, stabile, plissierte Faltenstruktur gelegte, dünne, schichtförmige Filtermatte (500) aus einem Vliesstoff mit einer Oberflächenprofilierung, wie Vertiefungen oder einer Wabenstruktur, versehen ist und mit einer Faltung mit einem Winkel zwischen zwei benachbarten Faltungsflächen von 15° bis 25°, insbesondere 19°, aufweist, und elektrostatisch aufgeladen ist, wobei die Porengröße des Filtermattenmaterials so gewählt ist, dass ein geringer Wasserdurchlass gegeben ist.

Die Vorrichtung zum Filtern von Luft kann insbesondere ein Luftfiltereinsatz für Filterlüfter oder Austrittsfilter von Schaltschränken sein, wobei die Vorrichtung zwischen ihren den verschiedenen Filterseiten zugewandten Außenflächen eine vorgegebene maximale Schichtdicke nicht überschreitet. Anders als bei den bekannten Vorrichtungen wird die Schichtdicke jedoch nicht homogen und vollständig mit einem Filtermaterial gefüllt, sondern mindestens eine der genannten Außenflächen der Vorrichtung wird mit Vertiefungen ausgestattet, um so eine Vergrößerung der Oberfläche zu erzielen. Die Vorrichtung erreicht damit bei Beschränkung ihrer Ausdehnung auf ein vorgegebenes Volumen eine größere Luftdurchtrittsfläche, wodurch sich wiederum geringere Druckverluste durch den Filtervorgang ergeben. Dies erlaubt einen höheren Filterstrom bei gleicher Auslegung der Lüftergeräte beziehungsweise eine schwächere Auslegung dieser Geräte bei gleichem Volumenstrom. Die Betriebszeit derartiger Vorrichtungen wird erheblich erhöht, so dass größere Wartungsintervalle erreicht werden können.

Die Filtermatte ist in eine Faltenstruktur gelegt. Die Faltenstruktur lässt sich aus einer schichtförmigen Filtermatte besonders einfach herstellen und gewährleistet eine gute Durchströmbarkeit. Der bei massiven Filtermatten übliche Druckverlust wird auf diese Weise reduziert. Die den verschiedenen Seiten des Filters zugewandten Oberflächen der Filtermatte können ein Mehrfaches der Grundfläche des Filters betragen.

Die Filtermatte ist plissiert, d. h. dauerhaft in eine Faltenstruktur gelegt. Das Plissieren kann dabei werksseitig nach der Herstellung einer schichtförmigen Filtermatte erfolgen, so dass beim Einbau der Filtermatte in ein Trägergehäuse die gewünschte Struktur bereits vorhanden und stabil ausgebildet ist.

Des weiteren ist die Filtermatte elektrostatisch aufgeladen. Eine derartige Aufladung wirkt sich zum einen positiv auf die Filterungseigenschaften aus, zum anderen sorgt sie durch die Abstoßung gleichnamiger Ladungen dafür, dass die Vertiefungen der Oberflächen offen gehalten werden und die gewünschte Oberflächenvergrößerung somit nicht beeinträchtigt wird. Es wird nicht nur der mechanische Anlagerungseffekt, sondern auch der elektrostatische Anlagerungseffekt nutzbar gemacht. Dadurch ist eine große Netzstruktur des Filtermaterials möglich. Die freie Luftaustrittsfläche wird somit größer, was zur Folge hat, dass der Druckverlust geringer wird.

Für die Herstellung der Vorrichtung zum Filtern von Luft stehen verschiedene Materialien zur Verfügung. Vorzugsweise bestehen sie aus einem Vliesstoff, welcher ein hohes Rückhaltevermögen für auszufilternde Substanzen aufweist.

Die Porengröße des Filtermattenmaterials (bzw. Maschendichte bei gewirktem Material) ist dabei so gewählt, dass sich ein geringer Wasserdurchlass ergibt. Eindringendes Wasser kann somit an der Filtervorrichtung gesammelt und in Richtung der Schwerkraft nach unten abgeleitet werden. Das Wassersperrverhalten der Filtermatte ist deutlich besser gegenüber den konventionellen Matten.

Vorteilhafte Ausgestaltungen der Erfindung sind in den Unteransprüchen angegeben.

Gemäß einer bevorzugten Weiterbildung der Erfindung weist das Grundgehäuse des Filterlüfters oder Austrittsfilters Schnellbefestigungseinrichtungen auf, welche insbesondere in den Eckbereichen des Grundgehäuses ausgebildet sein können. Vorteilhafte Ausgestaltungen der Schnellbefestigungseinrichtungen sind in den Unteransprüchen beschrieben.

### Kurzbeschreibung der Zeichnung

Im Folgenden wird die Erfindung mit Hilfe der Figuren beispielhaft erläutert. Es zeigen:
- Fig. 1: einen Querschnitt durch einen Filterlüfter mit einer darin eingesetzten Filtermatte;
- Fig. 2: eine Aufsicht auf den Filterlüfter nach Figur 1;
- Fig. 3: einen Querschnitt durch das Grundgehäuse des Filterlüfters;
- Fig. 4: eine Aufsicht auf den Luftfiltereinsatz des Filterlüfters;
- Fig. 5: einen Querschnitt entlang der Linie B-B von Figur 4;
- Fig. 6: einen Querschnitt entlang der Linie A-A von Figur 4.
- Fig. 7: in einer Explosionsdarstellung den Filterlüfter mit in den Endbereichen seines Grundgehäuses ausgebildeten Schnellbefestigungseinrichtungen,
- Fig. 8: in einer schaubildlichen Ansicht den an einer Montangewand befestigten Filterlüfter in einer varianten Form,
- Fig. 9: in einer vergrößerten schaubildlichen Ansicht den Eckbereich A des Filterlüfters gemäß Fig. 8,
- Fig. 10: eine Vorderansicht des Filterlüfters mit teilweise entferntem vorderem Abdeckgehäuse,
- Fig. 11: eine Seitenansicht des Filterlüfters mit senkrecht geschnittenem Grundgehäuse und Abdeckgehäuse,
- Fig. 12: eine Außenansicht auf eine Flügelecke der Schnellbefestigungseinrichtung an dem Grundgehäuse des Filterlüfters,
- Fig.13: eine Innenansicht auf eine Flügelecke der Schnellbefestigung im Rahmen des Grundgehäuses des Filterlüfters.

### Detaillierte Beschreibung der Erfindung und bester Weg zur Ausführung der Erfindung

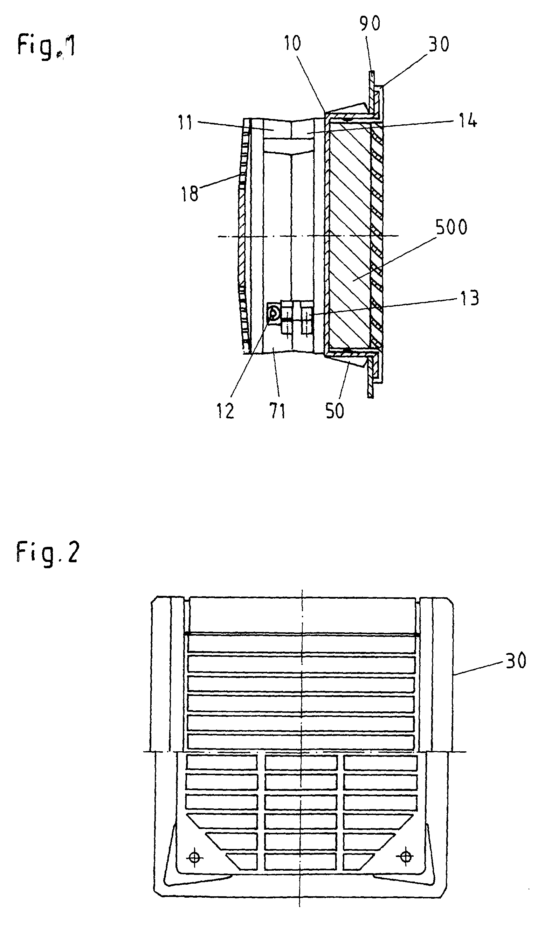

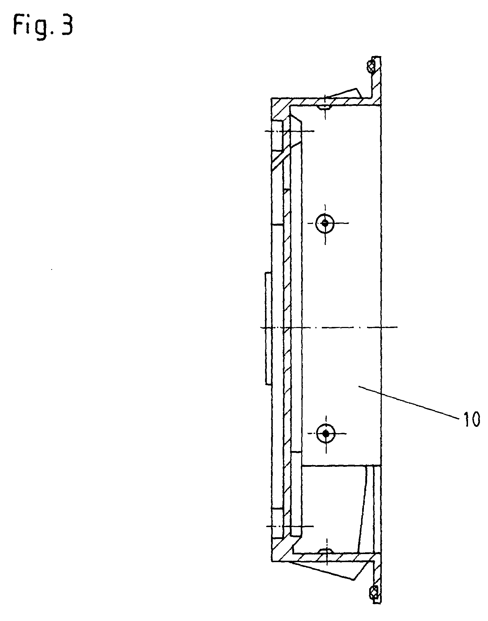

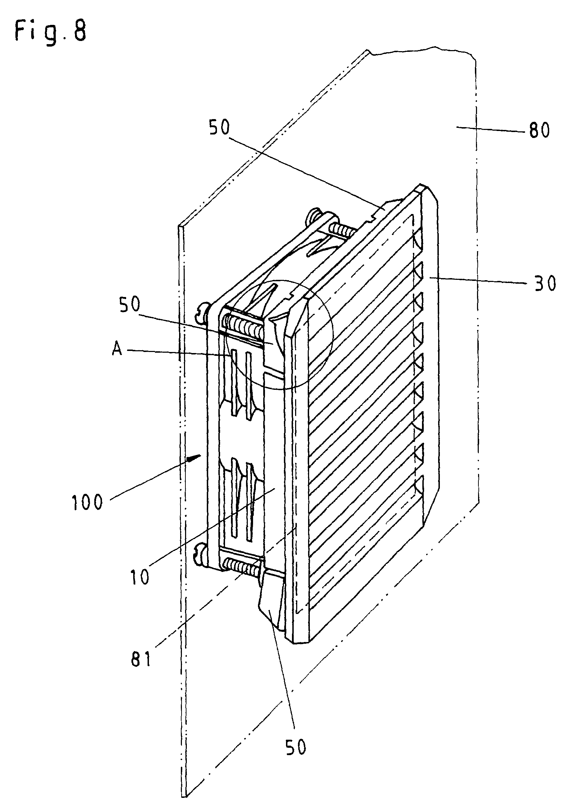

Der in Fig. 1 bis 3 dargestellte Filterlüfter besteht aus einem rahmenförmigen Grundgehäuse 10 mit einem gitterförmigen Boden 18, einer in das Grundgehäuse 10 eingesetzten Filtermatte 500, einem auf das Grundgehäuse 10 aufgesetzten und die Filtermatte 500 abdeckenden Designrahmen bzw. Abdeckgehäuse 30 und einem an dem Grundgehäuse 10 befestigten Lüftermotor 71, wobei das Grundgehäuse 10 an seinem Umfang mit einer schraubenlosen Schnellbefestigungseinrichtung 50 zur Montage des Filterlüfters in der Durchbrechung 81 einer Montagewand 80 versehen ist (vgl. Fig. 8). Der Designrahmen bzw. das Abdeckgehäuse 30 ist lamellenförmig oder gitterförmig unter Ausbildung einer entsprechenden Anzahl von Durchlässen und Durchbrechungen ausgebildet, wobei auch andere dekorative Ausgestaltungen für die Vorderfront des Designrahmens bzw. des Abdeckgehäuses 30 eingesetzt werden können. Gehäuse 10 und Lüftermotor sind über Nieten, Dübel oder Schrauben 11, 14 verbunden, und der Motor weist Klemmsteine 12, 13 für einen elektrischen Anschluss auf.

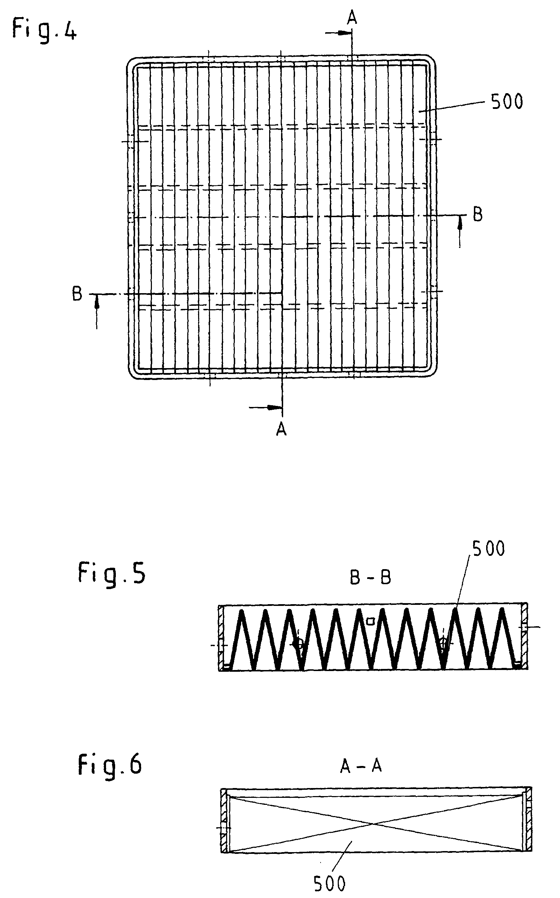

In den Figuren 4 bis 6 ist die erfindungsgemäß verwendete Filtermatte 500 in verschiedenen Ansichten dargestellt. Wie insbesondere aus Figur 5 erkennbar ist, handelt es sich bei der Filtermatte um eine dünne, schichtförmige Matte aus einem Vlies, welches gegebenenfalls auf beiden Seiten Beschichtungen aufweisen kann. Die Filtermatte ist in einer regelmäßige Folge von Falten angeordnet, so dass sich im Querschnitt von Figur 5 ein zickzackförmiger Verlauf ergibt. Der Winkel zwischen zwei benachbarten Faltungsflächen beträgt dabei 15° bis 25°, insbesondere 19°. Durch eine Anordnung des Filtermaterials in einer derartigen Faltenstruktur kann erreicht werden, dass die den beiden Seiten des Filters jeweils zugewandten Oberflächen der Filtermatte im Vergleich zu einer massiven Filtermatte um ein Vielfaches erhöht werden. Bei dem erwähnten Faltungswinkel von ca. 19° beträgt der Vergrößerungsfaktor zum Beispiel ca. 7 (sieben). Durch die vergrößerte Oberfläche tritt eine erhebliche Verringerung des Druckverlustes beim Durchströmen der Filtermatte ein, so dass die Effizienz des Filters gesteigert und eine längere Betriebszeit erreicht wird.

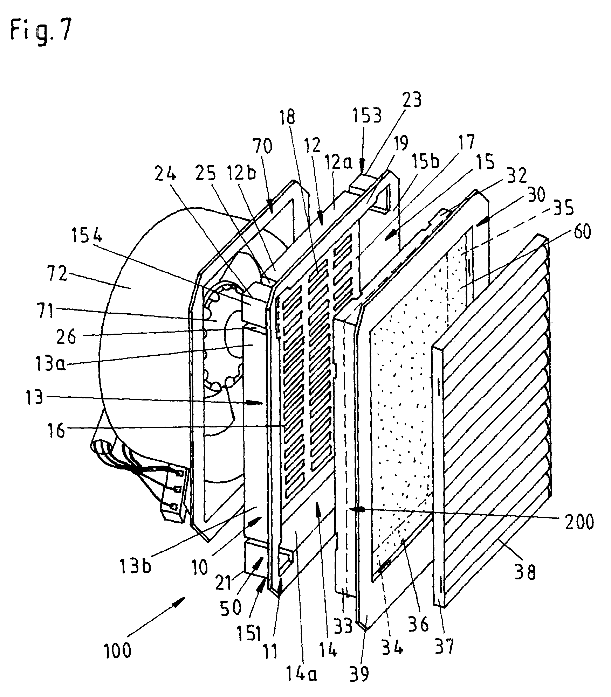

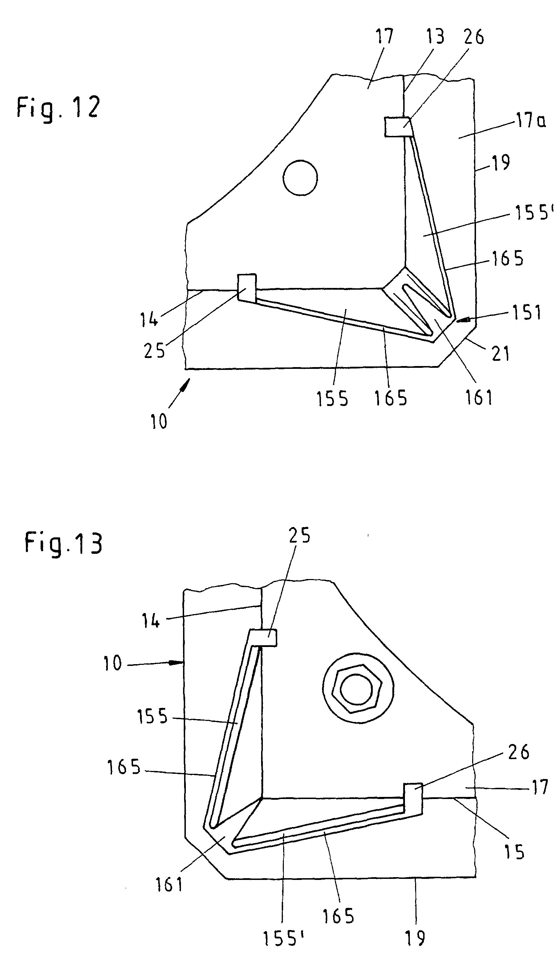

Der in den Fig. 7 bis 13 dargestellte und mit 100 bezeichnete Filterlüfter besteht nach einer bevorzugten Ausführungsform aus einem Grundgehäuse 10 mit einer Schnellbefestigungseinrichtungen 50 zur Befestigung des Filterlüfters 100 im Ausschnitt oder einer Durchbrechung einer Montagewand 80, einem in bzw. an dem Grundgehäuse 10 klemmend gehaltenen Abdeckgehäuse 30, einer in dem Abdeckgehäuse 30 angeordneten Filtermatte 60 der in den vorangegangenen Figuren 4 bis 6 beschriebenen Ausgestaltung und einem Gebläseträger 70 mit einem Gebläse 71, welches auch in einem Gehäuse 72 angeordnet sein kann.

Auf das Grundgehäuse 10 ist ein Einsatz 200 aufgesetzt und mit diesem verbunden. Das Abdeckgehäuse 30 kann auch als Designrahmen ausgebildet sein.

Das eine quadratische oder eine andere geometrische Form aufweisende Grundgehäuse 10 wird von einem Rahmen 11 mit vier Seitenwänden 12, 13, 14, 15 gebildet. Die Endbereiche der Seitenwände 12 bis 15 sind mit 12a und 12b, 13a und 13b, 14a und 14b und 15a und 15b bezeichnet (Fig. 7).

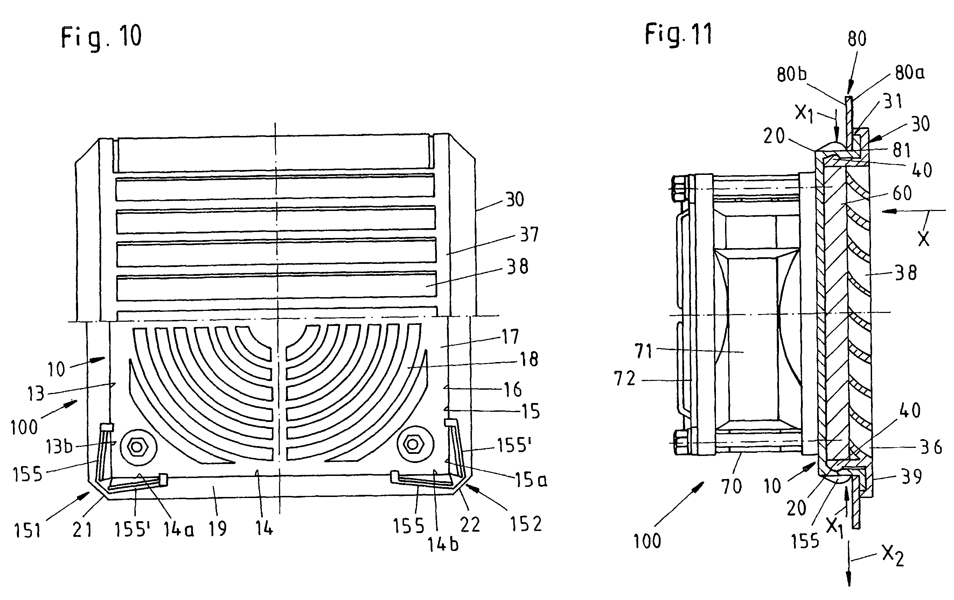

Die von dem Rahmen 11 des Grundgehäuses 10 gebildete Rahmenöffnung bzw. Durchbrechung 16 ist mittels eines plattenförmigen Zuschnittes 17 verschlossen, der als Berührungsschutzgitter 18 ausgebildet ist (Fig. 10).

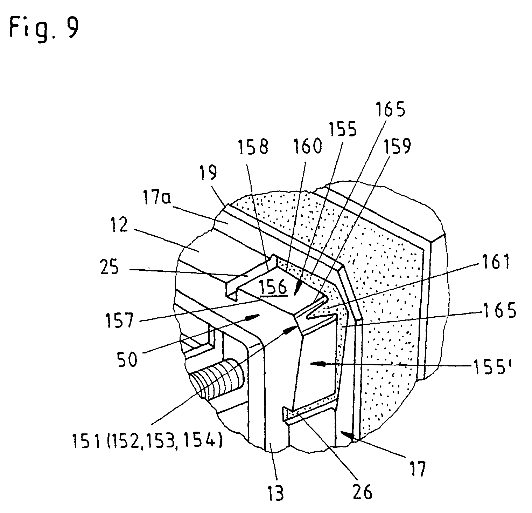

Die Ausbildung und Gestaltung des Berührungsschutzgitters 18 kann beliebig gewählt sein; wesentlich ist, dass eine ausreichende Anzahl von Durchbrechungen für eine Luftleitung bzw. -führung gegeben ist. Auch bei einem Filtermattenwechsel ist für eine Sicherheit zu sorgen, in dem ein Fingerberührungsschutz vorgesehen ist. Der Rahmen 11 mit dem plattenförmigen Zuschnitt 17 stellt vorzugsweise ein Formteil dar. Die Befestigung des plattenförmigen Zuschnittes 17 an den Seitenwänden 12 bis 15 des Rahmens 11 erfolgt vorzugsweise im mittleren Bereich der Seitenwände 12 bis 15 unter Freilassung und Ausbildung von Flügelecken 151, 152, 153, 154 in den Eckbereichen 21, 22, 23, 24 des Rahmens 11 (Fig. 9), worauf nachstehend noch näher eingegangen wird.

Der plattenförmige Zuschnitt 17 ist bis über die Seitenwände 12 bis 15 des Rahmens 11 unter Ausbildung eines umlaufenden Abschnittes 17a verlängert. Dieser umlaufende Abschnitt 17a bildet die Anlagekante bzw. den Anlagerand 19 im Bereich der Durchbrechung 81 der Montagewand 80. Dieser umlaufende Randabschnitt 17a kann auch als gesonderter Anschlagrahmen an den Seitenwänden 12 bis 15 angeformt und nicht integrierter Bestandteil des plattenförmigen Zuschnittes 17 sein. Der Rahmen 11 mit den Seitenwänden 12 bis 15 und dem plattenförmigen Zuschnitt 17 mit dem Berührungsschutzgitter 18 sowie mit der Montagewandanlagekante 19 bilden ein einstückiges Bauteil, welches z. B. im Spritzgussverfahren hergestellt ist.

Das an dem Grundgehäuse 10 mittels Klemmsitz gehaltene Abdeckgehäuse 30 besteht aus einem Rahmen 31 mit den Seitenwänden 32, 33; 34, 35, wobei dieser Rahmen 31 in Form und Abmessungen denen des Rahmens 11 des Grundgehäuses entspricht (Fig. 7, 8 und 11). Die Abmessungen des Rahmens 31 sind dabei so gehalten, dass das Abdeckgehäuse 30 mit seinem Rahmen 31 in den vom Rahmen 11 des Grundgehäuses 10 gebildeten Innenraum einführbar ist. Die Seitenwände 32 bis 35 liegen bei in das Grundgehäuse 10 eingesetztem Abdeckgehäuse 30 an den Innenwandflächen der Seitenwände 12 bis 15 des Rahmens 11 des Grundgehäuses 10 an.

Die von dem Rahmen 31 des Abdeckgehäuses 30 gebildete Öffnung 36 ist mittels einer Abdeckplatte 37 abgedeckt, die fester Bestandteil des Rahmens 31, jedoch auch ein selbstständiges Bauteil sein kann, das dann mittels Klemmsitz oder anderer geeigneter Verbindungsmittel in bzw. an dem Rahmen 31 des Abdeckgehäuses 30 gehalten ist. Die Abdeckplatte 37 ist mit einer Anzahl von Luftleitschlitzen 38 oder mit andersartig ausgebildeten Durchbrechungen für eine Luftleitung und -führung versehen. Die Ausbildung der Luftleitschlitze 38 in der Abdeckplatte 37 erfolgt vorzugsweise durch eine jalousieklappartige Ausgestaltung der Abdeckplatte mit feststehenden oder auch verstellbaren Klappen, wobei letztere Ausführungsform besonders vorteilhaft ist, wenn es sich um Filterlüfter 100 handelt, die größere Abmessungen aufweisen. Darüber hinaus besteht auch die Möglichkeit, die Abdeckplatte 37 mit andersartig ausgebildeten Durchbrechungen für eine Luftleitung bzw. -führung zu versehen; da nach erfolgtem Einbau des Filterlüfters 100 die Abdeckplatte 37 des auf das Grundgehäuse 10 ausgesetzten Abdeckgehäuses 30 eine Sichtfläche bildet, kann unter Ausbildung von Luftleitschlitzen oder Luftleitdurchbrechungen die Abdeckplatte 37 mit einem besonders gestalteten Design versehen sein.

Der Rahmen 31 des Abdeckgehäuses 30 ist mit einem senkrecht zu den Rahmenseitenwänden 32 bis 35 stehenden verlängerten Abschnitt versehen, der eine umlaufende Anlagekante 39 bildet, an der die Außenwandfläche des umlaufenden Abschnittes 17a des Rahmens 11 anliegt, wenn das Abdeckgehäuse 30 mit seinem Rahmen 31 in den Rahmen 11 des Grundgehäuses 10 eingeschoben ist. Die ausgebildete umlaufende Anlagekante 39 des Rahmens 31 des Abdeckgehäuses 30 kann an den Seitenwänden 32 bis 35 des Rahmens 31 angeformt sein; es besteht jedoch auch die Möglichkeit, diesen umlaufenden und die Anlagekante 39 bildenden Wandabschnitt durch eine entsprechend bemessene Abdeckplatte 37 zu schaffen, deren Abmessungen dann größer sind als die Außenabmessungen des Rahmens 31. Der umlaufende Rand dieses verlängerten, die Anlagekante 39 bildenden Abschnittes kann darüber hinaus noch in Richtung zum Rahmen 31 abgebogen sein, um den umlaufenden Rand des Abschnittes 17a des Rahmens 11 des Grundgehäuses 10 zu übergreifen, wenn das Grundgehäuse 10 mit dem Abdeckgehäuse 30 verbunden ist. Die Halterung des Abdeckgehäuses 30 an dem Grundgehäuse 10 erfolgt vermittels einer Klemmverbindung, die von an den Außenwandflächen der Seitenwände 32 bis 35 des Rahmens 31 des Abdeckgehäuses 30 ausgebildeten Nocken 40 und entsprechend angeordneten und ausgebildeten Vertiefungen 20 an den Innenwandflächen der Seitenwände 12 bis 15 des Rahmens 11 des Grundgehäuses 10 gebildet wird, so dass beim Einführen des Rahmens 31 des Abdeckgehäuses 30 in den Rahmen 11 des Grundgehäuses 10 die Nocken 40 an dem Rahmen 31 in die entsprechend profilierten Vertiefungen 20 am Rahmen 11 des Grundgehäuses 10 eingreifen (Fig. 11). Der Rahmen 31 des Abdeckgehäuses 30 ist so bemessen, dass dieser eine in der oben beschriebenen Weise ausgebildete Filtermatte 60 aufnehmen kann, die einerseits an der Innenwandfläche der Abdeckplatte 37 und andererseits der Innenwandfläche des Berührungsschutzgitters 18 des Rahmens 11 des Grundgehäuses 10 anliegt, wenn das Grundgehäuse 10 mit dem Abdeckgehäuse 30 verbunden ist.

Die an dem Grundgehäuse 10 vorgesehene Schnellbefestigungseinrichtungen 50 für den Filterlüfter 100 besteht bei einer Ausführungsform aus in den vier Eckbereichen 21, 22, 23, 24 des Rahmens 11 des Grundgehäuses 10 ausgebildeten federnd-elastischen Flügelecken 151, 152, 153, 154, wobei jedoch auch die Möglichkeit besteht nach einer weiteren Ausführungsform darin besteht, federnd-elastische Flügelecken nur in zwei Eckbereichen als Schnellbefestigungseinrichtung vorzusehen. Jede Flügelecke 151, 152, 153, 154, sowohl bei der Ausführungsform mit Flügelecken in vier Eckbereichen als auch bei einer Ausführungsform mit Flügelecken in nur zwei Eckbereichen, wird von zwei im rechten Winkel zueinander stehenden, aus den Flächen der im Eckbereich 21, 22, 23, 24 aneinander grenzenden Rahmenseitenwänden 12, 13 und 13, 14 und 14, 15 und 15, 12 und in Richtung zu den Eckbereichen 21, 22, 23, 24 aus den Ebenen der Rahmenseitenwände 12 bis 15 nach außen verlaufend herausgestellten, federnd-elastischen, flügelartigen Klemmabschnitten 155, 155' gebildet. Die Flügelecken 151 bis 154 in den Eckbereichen 21 bis 24 des Rahmens 11 sind alle gleich ausgebildet. Gleiche Ausbildung weisen auch die flügelartigen Klemmabschnitte 155, 155' der vier Flügelecken 151 bis 154 auf (Fig. 9, 12 und 13).

Die flügelartigen Klemmabschnitte 155, 155' einer jeden Flügelecke 151 bis 154 sind derart bemessen, dass zwischen deren oberen Kanten 160 und der die umlaufende Montagewandanlagekante 19 bildenden Wandfläche 17a ein Zwischenraum 165 ausgebildet ist.

Die flügelartigen Klemmabschnitte 155, 155' einer jeden Flügelecke 151 bis 154 sind in den Endbereichen 12a, 12b und 13a, 13b und 14a, 14b und 15a, 15b der Seitenwände 12 bis 15 des Rahmens 11 ausgebildet, so dass jede Seitenwand 12 bis 15 an ihren Endbereichen zwei flügelartige Klemmabschnitte 155 und 155' trägt, wobei diese Klemmabschnitte 155, 155' selbst nicht mit den Seitenwänden 12 bis 15 in Verbindung stehen, sondern an dem Zuschnitt 17 des Rahmens 112 angeformt sind (Fig. 9).

Da die beiden flügelartigen Klemmabschnitte 155, 155' gleich ausgebildet sind, wird nachstehend der flügelartige Klemmabschnitt 155 näher beschrieben. Dieser flügelartige Klemmabschnitt 155 besteht aus einem rechteckigen, plattenförmigen Zuschnitt 156 mit einer mit dem Grundgehäusezuschnitt 17 verbundenen Basiskante 157, zwei senkrecht auf dieser Basiskante 157 stehenden Seitenkanten 158, 159 und einer oberen Seitenkante 160. Die Seitenkante 158 steht dabei in etwa im rechten Winkel zur Basiskante 157, wohingegen die Seitenkante 159 leicht nach außen ausgestellt ist (Fig. 9), wobei auch beide flügelartigen Klemmabschnitte miteinander verbunden sein können. Des weiteren weist die Seitenkante 159 gegenüber der anderen Seitenkante 159 des plattenförmigen Zuschnittes 156 eine geringere Länge auf, so dass die obere Seitenkante 160 zur Basiskante 157 schräg verlaufend ist.

Die beiden derart ausgebildeten flügelartigen Klemmabschnitte 155, 155' sind in den Eckbereichen 21 bis 24 des Rahmens 11 in etwa im rechten Winkel zueinander stehend so angeordnet, dass ihre Seitenkanten 159 unter Freilassung eines geringen Abstandes 161 sich gegenüberliegend sind. Darüber hinaus ist jeder flügelartige Klemmabschnitt 155 bzw. 155' so bemessen, dass zwischen seiner oberen Seitenkante 160 und dem umlaufenden Abschnitt 17a mit der Montagewandanlagekante 19 ein Zwischenraum 165 gebildet wird, der in etwa der Materialstärke der Montagewand 80 entspricht. Beide flügelartigen Klemmabschnitte 155, 155' sind durch quer zur Längsrichtung der Seitenwände 12 bis 15 verlaufende Einschnitte 25, 26 von den Seitenwänden 12 bis 15 des Rahmens 11 des Grundgehäuses 10 getrennt, so dass die Flügelecken 151 bis 154 ausgebildet und ein für sich federnd-elastisches Element mit den flügelartigen Klemmabschnitten 155, 155' bilden. Dieser Zwischenraum 165 ist in Richtung zur Seitenkante 159 des flügelartigen Klemmabschnittes konisch sich erweiternd, so dass im Bereich der Seitenkante 158 der Zwischenraum 165 eine geringere Breite gegenüber der Breite des Zwischenraumes im Bereich der Seitenkante 159 aufweist. Dadurch ist es möglich, eine klemmende Halterung an der Montagewand auch dann zu erreichen, wenn die Montagewand unterschiedliche Blechstärken aufweist.

Durch die Ausstellung der flügelartigen Klemmabschnitte 155, 155' aus der von den Seitenwänden 12 bis 15 des Rahmens 11 gebildeten Ebene bilden die Außenflächen des plattenförmigen Zuschnittes 156 der flügelartigen Klemmabschnitte 155, 155' Gleitflächen, wodurch das Einschieben des Grundgehäuses 10 in die Durchbrechung 81 in der Montagewand 80 erleichtert wird (Fig. 11). Die Ausstellung der flügelartigen Klemmabschnitte 155, 155' erfolgt in Richtung zu demjenigen Bereich, in dem zwei flügelartige Klemmabschnitte 155, 155' einer jeden Flügelecke 151 bis 154 sich berühren, so dass die Ausstellung der flügelartigen Klemmabschnitte in Richtung zu den Eckbereichen in den oberen Bereichen der Klemmabschnitte erfolgt.

Das Grundgehäuse 10 und das Abdeckgehäuse 30 des Filterlüfters 100 bestehen vorzugsweise aus Kunststoffen, jedoch auch andersartige Werkstoffe können zur Herstellung dieser beiden Teile des Filterlüfters 100 herangezogen werden. Vorzugsweise werden solche Kunststoffe verwendet, die federnd-elastisch sind, um die federnd-elastische Wirkung der Flügelecken 151 bis 154 bzw. deren flügelartige Klemmabschnitte 155, 155' zu bewirken. Es besteht jedoch auch die Möglichkeit, nur das Grundgehäuse 10 aus derartigen Kunststoffen herzustellen, da an dem Grundgehäuse 10 die Schnellbefestigungseinrichtungen 50 angeordnet und ausgebildet ist. Wesentlich ist, dass die flügelartigen Klemmabschnitte 155, 155' federnd-elastisch sind und wenn diese aus ihrer Grundstellung herausbewegt worden sind, wieder in ihre Grundstellung selbsttätig zurückfedern.

Der Einbau des Filterlüfters 100 in die Wand 80 eines in der Zeichnung nicht dargestellten Schaltschrankes o. dgl. wird wie folgt durchgeführt.

Die Wand 80, an der der Filterlüfter 100 befestigt werden soll, wird mit einer der Querschnittsform des Filterlüfters 100 entsprechenden Durchbrechung 81 versehen (Fig. 11).

Die Abmessungen dieser Durchbrechung 81 entsprechen den Außenabmessungen des Rahmens 11 des Grundgehäuses 10. In diese Durchbrechung 81 wird das Grundgehäuse 10 mit seinem Rahmen 11 eingeführt, so dass der Rahmen 11 mit einem Abschnitt durch die Durchbrechung 81 in der Montagewand 80 hindurchgeführt ist. Das Einschieben des Rahmens 11 des Grundgehäuses 10 in die Durchbrechung 81 der Montagewand 80 erfolgt in Pfeilrichtung X. Da die flügelartigen Klemmabschnitte 155, 155' der Schnellbefestigungseinrichtungen 50 an dem Gehäuse 10 so ausgebildet und angeordnet sind, dass sich Gleitflächen ergeben, lässt sich der Rahmen 11 mühelos in die Durchbrechung 81 einführen, wobei gleichzeitig die flügelartigen Klemmabschnitte 155, 155' in Pfeilrichtung X1 in die Ebene der Seitenwände 12 bis 15 des Rahmens 11 gedrückt werden. Die Abmessungen der Durchbrechung 81 in der Montagewand 80 sind so gehalten, dass im eingedrückten Zustand die flügelartigen Klemmabschnitte 155, 155' der vier Flügelecken 151 bis 154 in die von den Seitenwänden 12 bis 15 des Rahmens 11 gebildete Ebene eindrückt werden, um den Rahmen 11 an den die Durchbrechung 81 begrenzenden Rändern hindurchführen zu können. Kommt der Rahmen 11 des Grundgehäuses 10 mit seiner Anlagekante 19 zur Anlage an der Außenwandfläche 80a der Montagewand 80, dann haben die flügelartigen Klemmabschnitte 155, 155' eine Stellung erreicht, in der sie aus der niedergedrückten Stellung in ihre Ausgangsstellung zurückfedern, was in Pfeilrichtung X2 erfolgt, so dass die flügelartigen Klemmabschnitte 155, 155' dann die in Fig. 11 wiedergegebene Stellung einnehmen, in der eine Verriegelung des Grundgehäuses 10 an der Montagewand 80 erfolgt. Der Gebläseträger 70 mit dem Gebläse 71 ist vor dem Einsetzen des Grundgehäuses 10 in die Durchbrechung 81 der Montagewand 80 bereits an dem Grundgehäuse 10 montiert, wobei die Abmessungen des Gebläseträgers 70 mit dem Gebläse 71 nicht über die Abmessungen des Rahmens 11 des Grundgehäuses 10 hinausgehen, so dass ein einwandfreies Hindurchführen des Gehäuseträgers 70 durch die Durchbrechung 81 in der Montagewand 80 beim Aufsetzen des Grundgehäuses 10 gewährleistet ist.

Nach der Verriegelung des Grundgehäuses 10 an der Montagewand 80 vermittels der flügelartigen Klemmabschnitte 155, 155' kann noch ein Nachzentrieren erfolgen, falls dies erforderlich sein sollte. Hieraufhin wird das Abdeckgehäuse 30 mit eingelegter Filtermatte 60 aufgesetzt, so dass der Rahmen 31 des Abdeckgehäuses 30 in den Innenraum des Rahmens 11 eingeführt wird. Es kommt dann die Klemmverbindung 20, 40 zum Einsatz, wodurch das Abdeckgehäuse 30 an dem Grundgehäuse 10 gehalten ist. Das Abdeckgehäuse 30 stützt sich dann mit seiner Anlagekante 30 an der Außenwandfläche 80a der Montagewand 80 ab.

Auch wenn die Montagewand 80 unterschiedliche Materialstärken aufweist, ist eine sichere Befestigung des Filterlüfters 100 an der Montagewand 80 möglich. Weist die Montagewand 80 eine größere Materialstärke auf, dann federn die flügelartigen Klemmabschnitte 155, 155' an den Eckbereichen des Gehäuses 10 nicht in ihre Ausgangsstellung zurück, wenn diese durch eine geringere Materialstärke der Montagewand 80 vorgegeben ist. Die Klemmabschnitte 155, 155' federn nur dann so weit zurück bis diese zur Anlage an der Montagewand 80 kommen. Aufgrund der durch das Rückfederungsvermögen gegebenen Kräfte wird der Filterlüfter 100 an der Montagewand 80 gehalten.

## Patentansprüche

1. Luftfiltereinsatz für Filterlüfter von Schaltschränken, unter Verwendung einer in eine Faltenstruktur gelegten Filtermatte (500),
**dadurch gekennzeichnet,**
**dass** die in eine dauerhafte, stabile, plissierte Faltenstruktur gelegte dünne, schichtförmige Filtermatte (500) aus einem Vliesstoff mit einer Oberflächenprofilierung, wie Vertiefungen oder einer Wabenstruktur, versehen ist und eine Faltung mit einem Winkel zwischen zwei benachbarten Faltungsflächen von 15° bis 25°, insbesondere 19°, aufweist und elektrostatisch aufgeladen ist, wobei die Porengröße des Filtermattenmaterials so gewählt ist, dass ein geringer Wasserdurchlass gegeben ist.

2. Filterlüfter (100) oder Austrittsfilter für den Einbau in die Wand eines Schaltschrankes o. dgl. wobei die Montagewand (80) mit einer Durchbrechung versehen ist, in der der Filterlüfter oder Austrittsfilter gehalten und befestigt ist, wobei der Filterlüfter oder Austrittsfilter ein Grundgehäuse (10) und einen Deckel (30) enthält, welche zwischen sich ein durch parallele Ebenen begrenztes Volumen zur Aufnahme eines Luftfiltereinsatzes definieren,
**dadurch gekennzeichnet,**
**dass** der Luftfiltereinsatz eine in eine dauerhafte, stabile, plissierte Faltenstruktur gelegte, dünne, schichtförmige Filtermatte (500) aus einem Vliesstoff mit einer Oberflächenprofilierung, wie Vertiefungen oder einer Wabenstruktur, versehen ist und mit einer Faltung mit einem Winkel zwischen zwei benachbarten Faltungsflächen von 15° bis 25°, insbesondere 19°, aufweist, und elektrostatisch aufgeladen ist, wobei die Porengröße des Filtermattenmaterials so gewählt ist, dass ein geringer Wasserdurchlass gegeben ist.

3. Filterlüfter nach Anspruch 2,
**dadurch gekennzeichnet,**
**dass** das Grundgehäuse (10) Schnellbefestigungseinrichtungen (50) aufweist, welche vorzugsweise in den Eckbereichen, insbesondere in den vier Eckbereichen bei einem viereckigen Grundgehäuse des Grundgehäuses ausgebildet sind.

4. Vorrichtung nach einem der Ansprüche 2 und 3,
**dadurch gekennzeichnet,**
**dass** der Filterlüfter (100) aus
a) einem eine quadratische oder eine andere geometrische Form aufweisenden Grundgehäuse (10) mit einem Rahmen (11) mit vier Seitenwänden (12, 13, 14, 15) , dessen Rahmenöffnung (16) mittels eines Berührungsgitters (18) verschlossen ist oder in deren Bereich ein Fingerberührungsschutz vorgesehen ist und der eine umlaufende Montagewandanlagekante (19) aufweist, wobei der Rahmen (11) an seinem Umfang mit einer schraubenlosen Schnellbefestigungseinrichtungen (50) versehen ist,
b) einem auf dem Grundgehäuse (10) mittels Klemmsitz (20, 40) gehaltenen Designrahmen bzw. Abdeckgehäuse (30) mit einer Anzahl von Luftleitschlitzen (38) oder Luftleitdurchbrechungen mit den verschiedensten geometrischen Formen,
c) einer zwischen dem Grundgehäuse (10) und dem Abdeckgehäuse (30) angeordneten und in diesem gehaltenen Filtermatte (60),
d) einem an dem Grundgehäuse (10) an der dem Abdeckgehäuse (30) abgewandten Seite befestigten Gebläseträger (70) mit einem Gebläse (71) und
e) einem auf das Grundgehäuse (10) aufgesetzten Einsatz besteht, wobei die Schnellbefestigungseinrichtungen (50) aus in den vier Eckbereichen (21, 22, 23, 24) des Rahmens (11) des Grundgehäuses (10) oder in zwei Eckbereichen des Grundgehäuses (10) ausgebildeten, federnd elastischen Flügelecken (151, 152, 153, 154) besteht, von denen jede Flügelecke (151; 152; 153; 154) von zwei im rechten Winkel zueinander stehenden, aus den Flächen der im Eckbereich (21; 22; 23; 24) aneinander grenzenden Rahmenseitenwänden (12, 13; 13, 14; 14, 15; 15, 12) und in Richtung zu den Eckbereichen (21, 22, 23, 24) aus den Ebenen der Rahmenseitenwände (12, 13, 14, 15) nach außen verlaufend herausgestellten federnd-elastischen flügelartigen Klemmabschnitten (155, 155') gebildet ist, wobei die flügelartigen Klemmabschnitte (155, 155') derart bemessen sind, dass zwischen deren oberen Kanten (160) und der die umlaufende Montagewandanlagekante (19) bildenden Wandfläche ein Zwischenraum (165) ausgebildet ist.

5. Filterlüfter nach Anspruch 4,
**dadurch gekennzeichnet,**
**dass** der Filterlüfter (100) aus
a) einem eine quadratische oder eine andere geometrische Form aufweisenden Grundgehäuse (10), das von einem plattenförmigen Zuschnitt (17) mit einer mittels eines Berührungsschutzgitters (18) verschlossenen Durchbrechung (16), von einem an dem Zuschnitt (17) angeformten Rahmen (11) mit vier Seitenwänden (12, 13, 14, 15) und von einem im mittleren Bereich einer jeden Seitenwand (12; 13; 14; 15) des Rahmens (11) angeformten, umlaufenden Anschlagrahmen als Montagewandanlagekante (19) gebildet ist, der gegenüber dem Rahmen (11) des Grundgehäuses (10) größere Abmessungen aufweist und der parallel zu dem Zuschnitt (17) verlaufend ist, wobei der Grundgehäuserahmen (11) an seinem Umfang mit einer schraubenlosen Schnellbefestigungseinrichtungen (50) versehen ist,
b) einem auf dem Grundgehäuse (10) mittels Klemmsitz (20, 40) gehaltenen Designrahmen bzw. Abdeckgehäuse (30) mit einer Anzahl von Luftleitschlitzen (38) oder Luftleitdurchbrechungen,
c) einer zwischen dem Grundgehäuse (10) und dem Abdeckgehäuse (30) angeordneten und in diesem gehaltenen Filtermatte (60),
d) einem an dem Grundgehäuse (10) an der dem Abdeckgehäuse abgewandten Seite befestigten Gebläseträger (70) mit einem Gebläse (71) und
e) einem auf das Grundgehäuse (10) aufgesetzten Einsatz
besteht, wobei die Schnellbefestigungseinrichtungen (50) aus in den vier Eckbereichen (21, 22, 23, 24) des Rahmens (11) des Grundgehäuses (10) oder in zwei Eckbereichen des Grundgehäuses (10) ausgebildeten, federnd elastischen Flügelecken (151, 152, 153, 154) besteht, von denen jede Flügelecke (151; 152; 153; 154) von zwei im rechten Winkel zueinander stehenden, aus den im Eckbereich (21; 22; 23; 24) aneinander grenzenden Rahmenseitenwänden (12, 13; 13, 14; 14, 15; 15, 12) geformten, federnd elastischen, etwa rechteckförmigen, flügelartigen Klemmabschnitten (155, 155') besteht, die an dem Grundgehäusezuschnitt (17) angeformt sind und deren Flügelflächen in Richtung zu den Eckbereichen(21; 22; 23; 24) aus den von den Rahmenseitenwänden (12, 13, 14, 15) gebildeten Ebenen ansteigend verlaufend herausgeführt sind, wobei die flügelartigen Klemmabschnitte (155, 155') derart bemessen sind, dass zwischen deren oberen Kanten (160) und der die umlaufende Montagewandanlagekante (19) bildenden Wandfläche ein Zwischenraum (165) ausgebildet ist.

6. Filterlüfter nach einem der Ansprüche 2 bis 5,
**dadurch gekennzeichnet,**
**dass** das Grundgehäuse (10) und der Designrahmen bzw. das Abdeckgehäuse (30) aus einem federnd elastischen Material, wie Kunststoff oder dergleichen, bestehen.

7. Filterlüfter nach einem der Ansprüche 2 bis 6,
**dadurch gekennzeichnet,**
**dass** die flügelartigen Klemmabschnitte (155, 155') einer jeden Flügelecke (151; 152; 153; 154) durch Einschnitte (25, 26) in den beiden aneinander grenzenden Rahmenseitenwänden (12, 13; 13, 14; 14, 15; 15, 12) ausgebildet und dadurch federnd elastisch mit einem Rückstellvermögen sind.

8. Filterlüfter nach einem der Ansprüche 2 bis 7,
**dadurch gekennzeichnet,**
**dass** der flügelartige Klemmabschnitt (155; 155') einer jeden Flügelecke (151; 152; 153; 154) von einem rechteckigen, plattenförmigen Zuschnitt (156) mit einer mit dem Grundgehäusezuschnitt (17) verbundenen Basiskante (157) , einer senkrecht auf dieser stehenden Seitenkante (158), einer im Winkel nach außen geneigt stehenden Seitenkante (159) mit einer gegenüber der Länge der senkrechten Seitenkante (158) geringeren Länge, und mit einer die beiden Seitenkanten (158, 159) miteinander verbindenden oberen Seitenkante (160) gebildet ist, die zur Basiskante (157) und in Richtung zu der Seitenkante (159) schräg verlaufend ist, wobei die Anordnung der beiden flügelartigen Klemmabschnitte (155, 155') einer jeden Flügelecke (151; 152; 153; 154) derart ist, dass die kürzeren Seitenkanten (159) der beiden flügelartigen Klemmabschnitte (155, 155') benachbart zueinander liegend und in einem geringen Abstand (161) voneinander angeordnet sind.

## Claims

1. Air filter insert for filter fan of switch cupboards by using a filter nat (500) laid in a folding structure,
**characterized in**
**that** the layer-shaped thin filter nat (500) laid in a permanent, stable, pleated folding structure of a nonwoven fabric is provided with a surface profile structure such as deepenings or a honeycomb structure and has a folding with an angle between two adjoining folding surfaces of 15° to 25°, in particular of 19° and is electrostatically loaded, whereby the pore size of the filter nat material is chosen such that a low water passage is given.

2. Filter fan (100) or outlet filter for the mounting into the wall of a switch cupboard or the like, whereby the mounting wall (80) is provided with an opening in which the filter fan or outlet filter is held and fixed, whereby the filter fan or outlet filter comprises a main housing (10) and a cover (30) which define between them a volume delimited by parallel surface planes for receiving an air filter insert,
charaterized in
that the air filter insert has a layer-shaped thin filter nat (500) laid in a permanent, stable, pleated folding structure of a nonwoven fabric with a surface profile structure such as deepenings or a honeycomb structure and with a folding with an angle between two adjoining folding surfaces of 15° to 25°, in particular of 19°, and is electrostatically loaded, whereby the pore size of the filter nat material is chosen such that a low water passage is given.

3. Filter fan according to claim 2,
**characterized in**
**that** the main casing (10) has quick coupling devices (50) which are configured preferably in the corner areas, in particular in the four corner areas for a tetragonal main casing of the main casing.

4. Device according to any of the claims 2 and 3,
**characterized in**
**that** the filter fan (100) consists of
a) a main casing (10) having a square or another geometrical shape with a frame (11) with four lateral walls (12, 13, 14, 15), the frame opening (16) of which is closed by means of a contact grid (18) or in the area of which a finger contact protection is provided and which has a peripheral mounting wall bearing edge (19), whereby the frame (11) is provided on its periphery with a screwless quick fixing device (50),
b) a design frame or a covering casing (30) held on the main casing (10) by press-fit (20, 40) with a number of air guiding slits (38) or air guiding openings with the most different geometrical shapes,
c) a filter nat (60) placed between the main casing (10) and the covering casing (30) and held therein,
d) a blast support (70) with a blast (71) fixed on the main casing (10) on the side turned away from the covering casing (30) and
e) an insert placed on the main casing (10), whereby the quick fixing device (50) consists of resilient wing corners (151, 152, 153, 154) configured in the four corner areas (21, 22, 23, 24) of the frame (11 ) of the main casing (10), among which each wing corner (151 ; 152 ; 153 ; 154) is formed by two wing-type resilient clamping sections (155, 155') standing at a right angle with each other, extending outwards from the surfaces of frame side walls (12, 13 ; 13, 14 ; 14, 15 ; 15, 12) adjoining in the corner area (21 ; 22 ; 23 ; 24) and in direction of the corner areas (21, 22, 23, 24) from the surface planes of the frame side walls (12, 13, 14, 15), whereby the wing-type clamping sections (155, 155') are dimensioned such that an intermediate space (165) is configured between their upper edges (160) and the wall surface which forms the peripheral mounting wall bearing edge (19).

5. Filter fan according to claim 4,
**characterized in**
**that** the filter fan (100) is formed by
a) a main casing (10) having a square or another geometrical shape which is formed by a plate-shaped blank (17) with an opening (16) closed by means of a contact protection grid (18), by a frame (11) with four lateral walls (12, 13, 14, 15) moulded on the blank (17) and by a peripheral stopping frame as mounting wall bearing edge (19), moulded in the middle area of each lateral wall (12 ; 13 ; 14 ; 15) of the frame (11), this stopping frame having bigger dimensions than the frame (11) of the main casing (10) and which is parallel to the blank (17), whereby the main casing frame (11) is provided on its periphery with a screwless quick fixing device (50),
b) a design frame or covering casing (30) held on the main casing (10) by press-fit (20, 40) with a number of air guiding slits (38) or air guiding openings,
c) a filter nat (60) placed between the main casing (10) and the covering casing (30) and held therein,
d) a blast support (70) with a blast (71) fixed on the main casing (10) on the side turned away from the covering casing and
e) an insert placed on the main casing (10),
whereby the quick fixing device (50) consists of resilient wing corners (151, 152, 153, 154) configured in the four corner areas (21, 22, 23, 24) of the frame (11) of the main casing (10), among which each wing corner (151 ; 152 ; 153 ; 154) is formed by two wing-type resilient approximately rectangular clamping sections (155, 155') standing at a right angle with each other, formed from the frame side walls (12, 13 ; 13, 14 ; 14, 15 ; 15, 12) adjoining in the corner area (21 ; 22 ; 23 ; 24) which are moulded on the main casing blank (17) and the wing surfaces of which are guided out ascendingly in direction of the corner areas (21, 22, 23, 24) from the surface planes formed by the frame side walls (12, 13, 14, 15), whereby the wing-type clamping sections (155, 155') are dimensioned such that an intermediate space (165) is configured between their upper edges (160) and the wall surface which forms the peripheral mounting wall bearing edge (19).

6. Filter fan according to any of the claims 2 to 5,
**characterized in**
**that** the main casing (10) and the design frame or the covering casing (30) are made of a resilient material such as plastics or the like.

7. Filter fan according to any of the claims 2 to 6,
**characterized in**
**that** the wing-type clamping sections (155, 155') of each wing corner (151 ; 52 ; 153 ; 154) is configured by notches (25, 26) in the two adjoining frame side walls (12, 13 ; 13, 14 ; 14, 15 ; 15, 12) and are thus resilient with a spring return force.

8. Filter fan according to any of the claims 2 to 7,
**characterized in**
**that** the wing-type clamping section (155 ; 155') of each wing corner (151 ; 152 ; 153 ; 154) is formed by a rectangular plate-shaped blank (156) with a base edge (157) connected with the main casing blank (17), a lateral edge (158) perpendicular thereon, a lateral edge (159) standing inclined outwards in an angle with a length less than that of the perpendicular lateral edge (158) and with an upper lateral edge (160), connecting the two lateral edges (158, 159) with each other, which is oblique to the base edge (157) and in direction to the lateral edge (159), whereby the arrangement of the two wing-type clamping sections (155, 155') of each wing corner (151 ; 152 ; 153 ; 154) is such that the shorter lateral edges (159) of the two wing-type clamping sections (155, 155') are placed adjoining to each other and at a short distance (161) from each other.

## Revendications

1. Insert de filtre à air pour filtre d'aérateur d'armoires de commande en utilisant une natte de filtre mise en une structure à plis (500),
**caractérisé en ce**
**que** la mince natte de filtre en forme de couche (500), mise en une structure à plis plissée, permanente, stable, en un tissu non-tissé, est pourvue d'un profilage de surface comme des enfoncements ou une structure en nid d'abeilles et présente un plissement avec un angle entre deux surfaces de plissement voisines de 15° à 25°, en particulier de 19°, et est chargée électrostatiquement, la grandeur des pores du matériau de la natte de filtre étant sélectionnée telle qu'il existe un faible passage d'eau.

2. Aérateur à filtre (100) ou filtre de sortie pour le montage dans la paroi d'une armoire de commande ou équivalent, la paroi de montage (80) étant pourvue d'une découpure dans laquelle l'aérateur à filtre ou le filtre de sortie est maintenu et fixé, l'aérateur à filtre ou le filtre de sortie contenant un boîtier de base (10) et un couvercle (30) qui définissent entre eux un volume limité par des plans parallèles pour loger un insert de filtre à air,
**caractérisé en ce**
**que** l'insert de filtre à air présente une mince natte de filtre plissée en forme de couche (500), mise en une structure plissée, permanente, stable, en un tissu non-tissé est pourvu d'un profilage de surface comme des enfoncements ou une structure en nid d'abeilles et d'un plissement avec un angle entre deux surfaces de plissement voisines de 15° à 25°, en particulier de 19°, et est chargé électrostatiquement, la grandeur des pores du matériau de la natte de filtre étant sélectionnée telle qu'il existe un faible passage d'eau.

3. Aérateur à filtre selon la revendication 2,
**caractérisé en ce**
**que** le boîtier de base (10) présente des dispositifs de fixation rapide (50) qui sont configurés de préférence dans les zones de coin du boîtier, en particulier dans les quatre zones de coin pour un boîtier de base tétragone.

4. Dispositif selon l'une des revendications 2 et 3,
**caractérisé en ce**
**que** l'aérateur à filtre (100) est constitué par
a) un boîtier de base (10) qui présente une forme carrée ou une autre forme géométrique avec un cadre (11) avec quatre parois latérales (12, 13, 14, 15), dont l'ouverture de cadre (16) est fermée au moyen d'une grille de contact (18) ou dans la zone desquelles il est prévu une protection de contact pour le doigt et qui présente une arête d'appui périphérique contre la paroi de montage (19), le cadre (11) étant pourvu, sur sa périphérie, d'un dispositif de fixation rapide sans vis (50),
b) un cadre design ou un boîtier de recouvrement (30) maintenu par coïncement (20, 40) sur le boîtier de base (10) avec un nombre de fentes de guidage de l'air (38) ou des découpures de guidage de l'air avec les formes géométriques les plus diverses,
c) une natte de filtre (60) placée entre le boîtier de base (10) et le boîtier de recouvrement (30) et maintenue dans celui-ci,
d) un support de soufflante (70) avec une soufflante (71) fixé sur le boîtier de base (10) sur le côté détourné du boîtier de recouvrement (30) et
e) un insert posé sur le boîtier de base (10), le dispositif de fixation rapide (50) étant constitué par des coins à ailettes (151, 152, 153, 154) élastiques configurés dans les quatre zones de coin (21, 22, 23, 24) du cadre (11) du boîtier de base (10) ou dans deux zones de coin du boîtier de base (10), parmi lesquels chaque coin à ailette (151 ; 152 ; 153 ; 154) est formé par deux sections de serrage du type ailette, élastiques (155, 155'), perpendiculaires à angle droit l'une par rapport à l'autre, s'étendant vers l'extérieur à partir des surfaces des parois latérales de cadre (12, 13 ; 13, 14 ; 14, 15 ; 15, 12) adjacentes l'une à l'autre dans la zone de coin (21 ; 22 ; 23 ; 24) et allant en direction des zones de coin (21, 22, 23, 24) hors des plans des parois latérales du cadre (12, 13, 14, 15), les sections de serrage de type ailette (155, 155') étant dimensionnées telles qu'il est configuré un espace intermédiaire (165) entre leurs arêtes supérieures (160) et la surface de paroi qui forme l'arête d'appui périphérique (19) contre la paroi de montage.

5. Aérateur à filtre selon la revendication 4,
**caractérisé en ce**
**que** l'aérateur à filtre (100) est constitué par
a) un boîtier de base (10), qui présente une forme carrée ou une autre forme géométrique, qui est formé par une pièce découpée en forme de plaque (17) avec une découpure (16) fermée au moyen d'une grille de protection de contact (18), par un cadre (11) avec quatre parois latérales (12, 13, 14, 15) moulé sur la pièce découpée (17) et par un cadre de butée périphérique comme arête d'appui contre la paroi de montage (19), moulé dans la zone centrale de chacune des parois latérales (12 ; 13 ; 14 ; 15) du cadre (11 ), qui a des dimensions plus grandes que le cadre (11) du boîtier de base (10) et qui est parallèle à la pièce découpée (17), le cadre du boîtier de base (11) étant pourvu, sur sa périphérie, d'un dispositif de fixation rapide sans vis (50),
b) un cadre design ou un boîtier de recouvrement (30) maintenu par coïncement (20, 40) sur le boîtier de base (10) avec un nombre de fentes de guidage de l'air (38) ou des découpures de guidage de l'air,
c) une natte de filtre (60) placée entre le boîtier de base (10) et le boîtier de recouvrement (30) et maintenue dans celui-ci,
d) un support de soufflante (70) avec une soufflante (71) fixé sur le boîtier de base (10) sur le côté détourné du boîtier de recouvrement (30) et
e) un insert posé sur le boîtier de base (10),
le dispositif de fixation rapide (50) étant constitué par des coins à ailettes (151, 152, 153, 154) élastiques configurés dans les quatre zones de coin (21, 22, 23, 24) du cadre (11) du boîtier de base (10) ou dans deux zones de coin du boîtier de base (10), parmi lesquels chaque coin à ailettes (151 ; 152 ; 153 ; 154) est constitué par deux sections de serrage du type ailette, élastiques (155, 155'), approximativement rectangulaires, perpendiculaires à angle droit l'une par rapport à l'autre, moulées dans la zone de coin (21 ; 22 ; 23 ; 24) à partir des parois latérales de cadre adjacentes l'une à l'autre (12, 13 ; 13, 14 ; 14, 15 ; 15, 12) qui sont moulées sur la pièce découpée du boîtier de base (17) et dont les moitiés d'ailette sont guidées en sortant en montant en direction des zones de coin (21 ; 22 ; 23 ; 24) à partir des plans formés par les parois latérales de cadre (12, 13, 14, 15), les sections de serrage de type ailette (155, 155') étant dimensionnées telles qu'il est configuré un espace intermédiaire (165) entre leurs arêtes supérieures (160) et la surface de paroi qui forme l'arête d'appui périphérique (19) contre la paroi de montage.

6. Aérateur à filtre selon l'une des revendications 2 à 5,
**caractérisé en ce**
**que** le boîtier de base (10) et le cadre design ou le boîtier de recouvrement (30) sont en un matériau élastique comme le plastique ou équivalent.

7. Aérateur à filtre selon l'une des revendications 2 à 6,
**caractérisé en ce**
**que** les sections de serrage du type ailette (155, 155') de chaque coin à ailette (151 ; 152 ; 153 ; 154) sont configurées par des incisions (25, 26) dans les deux parois latérales du cadre (12, 13 ; 13, 14 ; 14, 15 ; 15, 12) adjacentes l'une à l'autre et sont ainsi élastiques avec une reprise élastique.

8. Aérateur à filtre selon l'une des revendications 2 à 7,
**caractérisé en ce**
**que** la section de serrage du type ailette ( 155 ; 155') de chaque coin à ailette (151 ; 152 ; 153 ; 154) est formée par une pièce découpée (156) rectangulaire en forme de plaque avec une arête de base (157) reliée à la pièce découpée du boîtier de base (17), une arête latérale (158) perpendiculaire sur celle-ci, une arête latérale (159) debout inclinée vers l'extérieur en un angle avec une longueur inférieure à la longueur de l'arête latérale perpendiculaire (158) et avec une arête latérale supérieure (160), qui relie les deux arêtes latérales (158, 159) l'une à l'autre, qui est oblique vers l'arête de base (157) et en direction de l'arête latérale (159), la disposition des deux sections de serrage de type ailette (155, 155') de chaque coin à ailette (151 ; 52 ; 153 ; 154) étant telle que les arêtes latérales plus courtes (159) des deux sections de serrage de type ailette (155, 155') sont situées voisines l'une de l'autre et sont placées à une faible distance (161) l'une de l'autre.
